Europäisches Patentamt

European Patent Office

Office européen des brevets

(11) Publication number : **0 234 387 B1**

(12) **EUROPEAN PATENT SPECIFICATION**

(45) Date of publication of patent specification :
07.06.95 Bulletin 95/23

(51) Int. Cl.⁶ : **G03F 7/42**

(21) Application number : **87101772.9**

(22) Date of filing : **09.02.87**

(54) Method of removing photoresist on a semiconductor wafer.

(30) Priority : **14.02.86 JP 30327/86**

(43) Date of publication of application :
**02.09.87 Bulletin 87/36**

(45) Publication of the grant of the patent :
**07.06.95 Bulletin 95/23**

(84) Designated Contracting States :
**DE FR GB**

(56) References cited :
EP-A- 0 216 603
US-A- 4 241 165
US-A- 4 292 384
JOURNAL OF THE ELECTROCHEMICAL SOCI-
ETY, vol. 131, no. 5, May 1984, pages
1164-1169, Manchester, New Hampshire, US;
J.J. HANNON et al.: "Oxidative removal of
photoresist by oxygen/freon 116 discharge
products"
JOURNAL OF THE ELECTROCHEMICAL SOCI-
ETY, vol. 114, no. 8, August 1967, page 213C,
abstract no. 180, Manchester, New
Hampshire, US; S.M. IRVING: "A dry photores-
ist removal method"

(73) Proprietor : **FUJITSU LIMITED**
**1015, Kamikodanaka**
**Nakahara-ku**
**Kawasaki-shi Kanagawa 211 (JP)**

(72) Inventor : **Fujimura, Shuzo FUJITSU LIMITED**
**Patent Department**
**Kosugi Fujitsu Building**
**1812-10 Shimonumabe**
**Nakahara-ku Kawasaki-shi Kanagawa 211**
**(JP)**
Inventor : **Motoki, Yasunari FUJITSU LIMITED**
**Patent Department**
**Kosugi Fujitsu Building**
**1812-10 Shimonumabe**
**Nakahara-ku Kawasaki-shi Kanagawa 211**
**(JP)**
Inventor : **Kato, Yoshikazu FUJITSU LIMITED**
**Patent Department**
**Kosugi Fujitsu Building**
**1812-10 Shimonumabe**
**Nakahara-ku Kawasaki-shi Kanagawa 211**
**(JP)**

(74) Representative : **Greenstreet, Cyril Henry et al**
**Haseltine Lake & Co.**
**Hazlitt House**
**28 Southampton Buildings**
**Chancery Lane**
**London WC2A 1AT (GB)**

## Description

This invention relates to an improved method of removing a photoresist film on a semiconductor wafer by means of a reactive plasma.

In general, in fabricating semiconductor devices a semiconductor wafer masked with a patterned photoresist film is chemically treated, for example by etching. After the wafer has been etched the photoresist is no longer needed and must be removed. Removal of the used photoresist has been carried out by a wet chemical treatment. However, if the photoresist has been affected by the treatment of the wafer the used photoresist cannot be readily removed by the wet chemical treatment.

The photoresist is affected in the following cases.

(a) When the wafer is ion implanted the surface of the photoresist is also ion implanted, causing dissociation of hydrogen and oxygen atoms therefrom so that carbonate of the photoresist material is produced on the surface.

(b) Fluorine radicals in a gas mixture, such as the mixture of carbon tetrafluoride ($CF_4$) with 5 to 30% oxygen ($O_2$) generally used for etching polycrystalline silicon or silicon dioxide ($SiO_2$), produces fluoride of the photoresist. This fluoride cannot be removed by the wet chemical treatment.

(c) Chlorine or chloride gas, e.g. $CCl_4$, used in a reactive ion etching (referred to hereinafter as RIE) for etching aluminium produces aluminium chloride ($AlCl_3$), which deposits on the surface of the photoresist.

(d) $CF_4$ used in RIE produces polymers such as $CF_1$, $CF_2$, etc., on the surface of the photoresist. These polymers are difficult to remove by wet chemical treatment.

In order to remove affected photoresists which cannot be readily removed by wet chemical treatment an ashing method has been employed. The ashing is carried out by exposing the photoresist in an oxygen plasma, which can be provided by conventional plasma etching apparatus. The mechanism of the plasma ashing is mainly dissociation of the atomic bond in the photoresist material by bombardment with charged particles and with ultra-violet radiation, both generated in the plasma. The raised temperature of the photoresist also helps the dissociation. Thus dissociated atoms are chemically activated to combine with oxygen to produce, for example, $CO_2$, which is volatile and easy to remove. During the ashing process the surface portion of the photoresist which has been affected by the previous treatment of the wafer is slow or difficult to decompose, but the inner side of the photoresist is thermally decomposed and at the same time softened because the photoresist is composed of plastic resin such as poly-methyl methacrylate. In the ashing treatment, the affected surface of the photoresist is turned into small particles that stick to the surface of the wafer and must be removed by a wet chemical washing. However, particles removed in this way remain in the chemical solution, and may deposit again on the surface of the wafer. Deposition of the particles on the wafer surface decreases the production yield and lowers the quality of the product.

The recent trend to high density semiconductor fabrication has created further problems:

A. Ion implantation is increasingly employed, particularly for fabricating highly doped regions, for example the region between source and drain. During the ion implantation the photoresist film is also attacked, and more resistant affected material, which is more difficult to remove, is formed on the surface of the resist film, particularly when heavy ions, such as phosphorus ion ($P^+$) or arsenic ion ($As^+$), are implanted in large doses, e.g. $1 \times 10^{15}$ cm$^{-2}$ or more.

B. The requirement for higher integration density makes the device more sensitive to the residual particles.

C. High energy irradiation by RIE by sputtering is effective to remove the resistant affected photoresist described in paragraph A above. However, in this method the high energy active species may more easily cause softening of the unaffected inner side of the photoresist, so that the affected surface portion of the photoresist sinks into the softened inner portion. The sunken affected surface is thus prevented from being adequately bombarded and finally sticks to the surface of the wafer. Thus, more of the affected portions stick on to the wafer as particles. The high energy RIE bombardment of the wafer may also impair the quality of the semiconductor products made from this wafer.

As seen in the above description, and as reported by R. L. Maddox et al. in "Applications of Reactive Plasma Practical Microelectronics Processing Systems", SOLID STATE TECHNOLOGY, April 1978, there has been no suggestion of nor need for cooling the wafers and the photoresist during the removal of the photoresist. Rather, it is advantageous for the photoresist to be kept at a high temperature to increase the ashing rate, i.e. the speed of reducing the photoresist. On the other hand during plasma etching of the wafer itself the semiconductor wafer has been cooled, as was proposed by the inventor in provisional publication of Japanese Utility Patent, 56-14366. The advantage of cooling a semiconductor wafer during etching of the wafer is as follows. The plasma, always having a high temperature, heats the wafer as well as the photoresist on its surface, thus promoting deterioration (e.g. decomposition) and deformation (i.e. softening) of the photoresist. The deteriorated photoresist is more liable to be etched during the wafer etching process. Therefore, the wafer has been cooled to avoid deterioration and deformation of the photoresist. Thus, the etching selection ratio, i.e. the ratio of the rate of etching of the portion to be etched to that of the photoresist, or the rate of etching of the portion to be etched to that of the underlayer, such as silicon dioxide or phosphorus silicate glass, could be improved, resulting in accuracy of fabrication.

EP-A-0 216 603 relates to etching/stripping of photoresist. It discloses apparatus in which the temperature of a wafer can be controlled by a heating or cooling device. Cooling is specifically mentioned for preserving the photoresist.

US-A-4 292 384 discloses plasma etching apparatus for development of resists, for etching of semiconductor devices, for fabrication of photomasks, and for removal of resists. The apparatus has a low voltage DC plasma source and (a) means for controlling the temperature of the plasma and (b) further means for controlling the temperature of the target of the plasma processing - by heating or cooling. It is mentioned that ashing of most photoresists leaves objectionable residues. It is stated that even residual inorganic residues from the photoresist may be simultaneously removed by utilising mixtures of halogen containing gases with oxygen during the ashing procedure.

A general object of the invention is to provide a method of efficiently removing affected photoresist without causing damage to the wafer.

According to the present invention, this is achieved by the means set forth in claim 1, in which photoresist on a semiconductor wafer, and particularly affected photoresist, is removed by a reactive gas plasma while the wafer is cooled by a cooling device. Increase in temperature of the photoresist during its removal in the gas plasma is thus suppressed and softening of the unaffected inner portion of the photoresist is prevented so that it can support the affected surface portion. Consequently the affected surface portion does not sink into the inner side of the photoresist, so that bombardment of the affected surface of the photoresist by the plasma is ensured before the affected surface region sticks to the wafer surface, resulting in good removal of the photoresist.

The invention will now be described in more detail by way of example with reference to the accompanying drawings, in which:

Fig. 1 is a diagrammatic cross-sectional view of a barrel-type plasma treatment apparatus, illustrating a first embodiment of the present invention; and

Fig. 2 is a diagrammatic cross-sectional view of a single wafer plasma treatment apparatus, forming a second embodiment of the present invention.

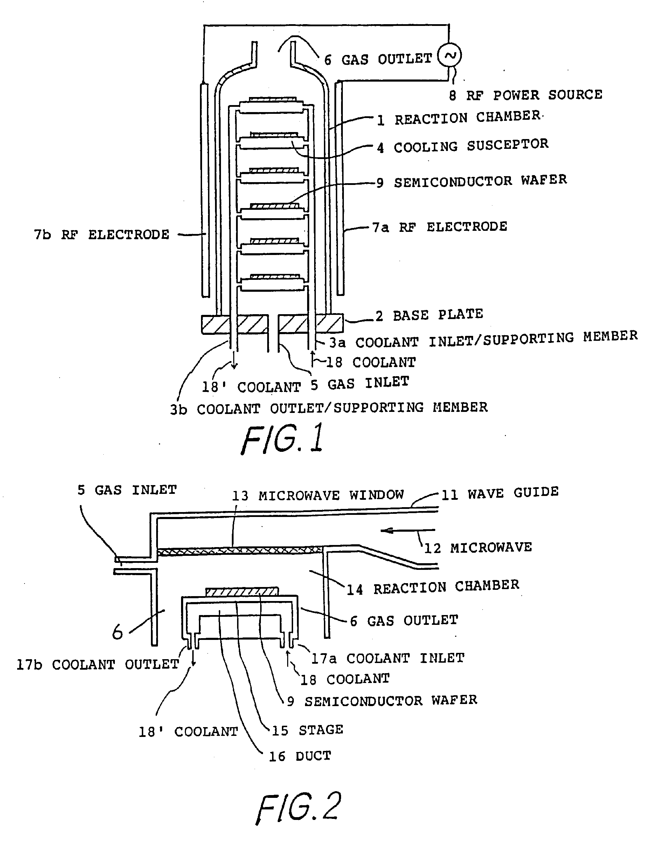

The construction and operation of preferred embodiments of the invention will be described with reference to a radio frequency plasma treatment apparatus of the so-called barrel type for removing the affected photoresist on a plurality of semiconductor wafers, as illustrated in Fig. 1. Semiconductor wafers 9, e.g. carrying a photoresist layer 1.2 $\mu$m thick of which the surface has been undesirably affected as a result of implantation in an earlier step of fabrication with as many as $3 \times 10^{15}$ phosphorus ions ($P^+$) per square cm at an acceleration energy of 120 KeV, are loaded with their photoresist-coated surface upwards, on to cooling susceptors 4 arranged in a reaction chamber 1. The cooling susceptors 4 are cooled by coolant 18, 18' flowing therethrough, introduced from a coolant inlet 3a and drained through a coolant outlet 3b. The coolant inlet 3a and the coolant outlet 3b are made of pipe, and also act as supporting members of the cooling susceptors 4. The reaction chamber 1 is made of dielectric material, for example quartz, and is shaped like a cylinder. The chamber 1 is open at the bottom and has a flat open edge, and is set on the flat surface of a base plate 2 to form a vacuum seal. A reactive gas, predominantly oxygen gas ($O_2$), is fed through a gas inlet 5 at a flow rate of approximately 500 cc/min into the reaction chamber 1. At the same time, the reaction chamber 1 is evacuated through the gas outlet 6 by a vacuum pump (not shown) to keep the inside of the chamber 1 at a vacuum of approximately 1 Torr ($1.33 \times 10^2$ Pa). RF power, e.g. approximately 1.5 KW at 13.56 MHz, is supplied from an RF power source 8 for from 3 to 5 minutes to RF electrodes 7a and 7b, both arranged outside the chamber 1, or to an RF coil (not shown) in place of these electrodes, to produce a plasma in the reaction chamber 1. The $O_2$ plasma readily reacts with and decomposes the affected surface of the photoresist on the semiconductor wafers, while the inner side of the photoresist, cooled by the coolant flowing through the cooling susceptor 4, is still hard enough to support the affected surface of the photoresist. Thus very little of the affected photoresist remains on the surface of the wafer. As an alternative RF power source, 400 W at 400 KHz may be employed to produce a strong plasma sputtering at 1 Torr ($1.33 \times 10^2$ Pa) of oxygen gas. The effect of the cooling of the wafer in accordance with the present invention is shown by the data below.

| Temperature of the coolant | Amount of residual particles per some specific area | |
| --- | --- | --- |
| | Data 1 | Data 2 |
| 27.4 °C | 190 | 335 |
| – 1.1 °C | 142 | 245 |
| –14.1 °C | 107 | 140 |

Another embodiment of the invention for removing the photoresist in a single wafer system is shown in Fig. 2, where microwave power is employed to produce a gas plasma. The microwave power is supplied from a 2.45 GHz microwave power source (not shown) as shown by the arrow 12 through a wave guide 11, and fed into the reaction chamber 14, made of metal, through a microwave window 13 made of a dielectric material, e.g. quartz or ceramic.

A similar semiconductor wafer 9 having similar affected photoresist as in Fig. 1 is loaded on a stage 15 with the photoresist-coated surface upwards. The stage 15 is cooled by a coolant 18, 18' flowing through a duct 16 installed in the stage 15, introduced from a coolant inlet 17a and drained through a coolant outlet 17b. Other numerals designate same or corresponding parts of Fig. 1. A reactive gas ($O_2$) is fed from the gas inlet 5 into the interior of the reaction chamber 14 at a flow rate of approximately 200 cc/min. At the same time, the chamber 14 is evacuated by a vacuum pump (not shown) through a gas outlet 6 to keep the inside of the chamber under a vacuum of approximately 3 Torr ($4 \times 10^2$ Pa). Microwave power fed into the chamber 14 produces an oxygen plasma therein, which removes the photoresist in the same way as in the apparatus of Fig. 1. Good removal of the photoresist is confirmed after application of the microwave power for 3 to 5 minutes.

Application of grease to fix the wafer onto the susceptor 4 or stage 15 is effective to reduce the time needed for complete removal of the affected photoresist, because of the improved heat conduction between the wafer 9 and the susceptor 4 or stage 15.

Good removal of the affected photoresist is also confirmed when some argon gas (Ar) or nitrogen gas ($N_2$) is added to the oxygen gas to stabilize the plasma production, or when a fluoride gas, e.g. carbon tetrafluoride gas ($CF_4$), is added to the oxygen gas to promote the reaction.

Additional processes, wet chemical washing or downstream ashing, though not required in most cases, may be employed after the ashing process if necessary for better removal of the photoresist.

An embodiment of the invention thus provides a process in which photoresist on a semiconductor wafer that has been treated during a fabrication process, whereby the photoresist may have been rendered difficult to remove, is removed by exposure to reactive gas, e.g. oxygen plasma, while the wafer is cooled by a cooling device. The cooling device can be a susceptor or stage on which the wafer is placed, and coolant flows through a pipe or duct fitted thereto. Cooling of the wafer prevents the photoresist from being softened by the heat from the plasma, so that the inner side of the photoresist can be maintained hard enough to support the affected surface portion of the photoresist, preventing the affected surface portion from sticking on to the surface of the wafer. Therefore, the affected portion can be effectively irradiated by the plasma and decomposed without leaving residues on the wafer. Reduced residues on the wafer surface contribute to improved production yield and quality of the products made from the wafer.

Numerous modifications and changes will readily occur to those skilled in the art, and it is not desired to limit the invention to the exact construction and operation shown and described. Accordingly, all suitable modifications and equivalents may be resorted to, falling within the scope of the invention.

## Claims

1. A method of removing from a cooled semiconductor wafer, by reaction with an active gas plasma, a coating of resist of which the surface is resistant to removal by wet chemical treatment, characterised in that said surface layer is selectively removed by reaction with a plasma and volatilisation, whereby the plasma reacts with and decomposes the affected surface of the resist on the semiconductor wafer, while the inner side of the resist, cooled by a coolant flowing through a cooling susceptor (4) so as to prevent the underside of the resist coating from softening, is still hard enough to support the affected surface of the resist.

2. A method according to claim 1 in which the resistance of the surface of the resist to removal by wet chemical treatment is a result of ion implantation or reactive ion etching of the resist-coated wafer.

3. A method according to claim 1 or 2, in which a coolant is used having a temperature in the range -1.1 to -14.1°C.

4. A method according to any preceding claim, in which the plasma is of oxygen gas.

5. A method according to claim 4, in which the oxygen gas includes argon or nitrogen or both.

6. A method according to claim 5, in which the oxygen gas includes a fluoride gas.

7. A method according to any preceding claim, in which the plasma is produced by radio frequency excitation.

**Patentansprüche**

1. Ein Verfahren zum Entfernen von einem gekühlten Halbleiterwafer, durch Reaktion mit einem aktiven Gasplasma, einer Beschichtung aus Resist, dessen Oberfläche gegenüber dem Entfernen durch chemische Naßbehandlung beständig ist, dadurch gekennzeichnet, daß die genannte Oberflächenschicht durch Reaktion mit einem Plasma und durch Verflüchtigung selektiv entfernt wird, wodurch das Plasma mit der angegriffenen Oberfläche des Resists auf dem Halbleiterwafer reagiert und es zersetzt, während die innere Seite des Resists, die durch ein Kühlmittel gekühlt wird, das einen Kühlträger (4) durchfließt, um zu verhindern, daß die Unterseite der Resistbeschichtung erweicht, noch hart genug ist, um die angegriffene Oberfläche des Resists zu stützen.

2. Ein Verfahren nach Anspruch 1, bei dem die Beständigkeit der Oberfläche des Resists gegenüber dem Entfernen durch chemische Naßbehandlung ein Resultat einer Ionenimplantation oder eines reaktiven Ionenätzens des resist-beschichteten Wafers ist.

3. Ein Verfahren nach Anspruch 1 oder 2, bei dem ein Kühlmittel verwendet wird, das eine Temperatur in dem Bereich von -1,1 bis -14,1°C hat.

4. Ein Verfahren nach irgendeinem vorhergehenden Anspruch, bei dem das Plasma aus Sauerstoffgas ist.

5. Ein Verfahren nach Anspruch 4, bei dem das Sauerstoffgas Argon oder Stickstoff oder beides enthält.

6. Ein Verfahren nach Anspruch 5, bei dem das Sauerstoffgas ein Fluoridgas enthält.

7. Ein Verfahren nach irgendeinem vorhergehenden Anspruch, bei dem das Plasma durch Hochfrequenzerregung erzeugt wird.

**Revendications**

1. Procédé d'enlèvement, sur une plaquette semiconductrice refroidie, au moyen d'une réaction avec un plasma de gaz actif, d'un revêtement de réserve dont la surface résiste à l'enlèvement au moyen d'un traitement chimique par voie humide, caractérisé en ce que ladite couche de surface est ôtée sélectivement au moyen d'une réaction avec un plasma et au moyen d'une volatilisation et ainsi, le plasma réagit avec la surface affectée de la réserve située sur la plaquette semiconductrice et décompose celle-ci tandis que le côté interne de la réserve, refroidi par un agent de refroidissement qui circule au travers d'une dérivation de refroidissement (4) de manière à empêcher que le côté inférieur du revêtement de réserve ne soit ramolli, reste suffisamment dur pour supporter la surface affectée de la réserve.

2. Procédé selon la revendication 1, dans lequel la résistance de la surface de la réserve à l'enlèvement par un traitement chimique par voie humide est le résultat d'une implantation ionique ou d'une gravure ionique réactive de la plaquette revêtue de réserve.

3. Procédé selon la revendication 1 ou 2, dans lequel un agent de refroidissement est utilisé, lequel présente une température dans la plage de -1,1 à -14,1°C.

4. Procédé selon l'une quelconque des revendications précédentes, dans lequel le plasma est un plasma de gaz oxygène.

5. Procédé selon la revendication 4, dans lequel le gaz oxygène inclut de l'argon ou de l'azote ou les deux.

6. Procédé selon la revendication 5, dans lequel le gaz oxygène inclut un gaz fluor.

7. Procédé selon l'une quelconque des revendications précédentes, dans lequel le plasma est produit au moyen d'une excitation haute fréquence.

FIG.1

FIG.2